Europäisches Patentamt

European Patent Office

Office européen des brevets

(19)

(11) **EP 1 271 173 B1**

(12) **EUROPÄISCHE PATENTSCHRIFT**

(45) Veröffentlichungstag und Bekanntmachung des Hinweises auf die Patenterteilung:
**22.03.2006 Patentblatt 2006/12**

(51) Int Cl.:
***G01R 33/36*** (2006.01)

(21) Anmeldenummer: **02022487.9**

(22) Anmeldetag: **16.12.2000**

(54) **Verfahren zum Betrieb eines NMR-Spektrometers mit einem DDS-Generator**

Method of operating an NMR spectrometer with a DDS generator

Méthode d'opération d'un spectromètre RMN avec un générateur DDS

(84) Benannte Vertragsstaaten:
**CH FR GB LI NL**

(30) Priorität: **19.02.2000 DE 10007679**

(43) Veröffentlichungstag der Anmeldung:
**02.01.2003 Patentblatt 2003/01**

(62) Dokumentnummer(n) der früheren Anmeldung(en) nach Art. 76 EPÜ:
**00127633.6 / 1 130 411**

(73) Patentinhaber: **Bruker BioSpin AG**
**8117 Fällanden (CH)**

(72) Erfinder:
• **Schwilch, Arthur**
**8311 Brütten (CH)**

• **Gosteli, Christoph**
**Cambridge, MA 02139 (US)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 0 661 816**

• **L. GENGYING, X. HAIBIN: "Digital quadrature detection ..." REVIEW OF SCIENTIFIC INSTRUMENTS, Bd. 70, 1999, Seiten 1511-1513, XP002229295**
• **F. MOMO ET AL.: "Digital frequency synthesizers ..." REVIEW OF SCIENTIFIC INSTRUMENTS, Bd. 65, 1994, Seiten 3291-3293, XP002229296**

EP 1 271 173 B1

**Beschreibung**

Die Erfindung betrifft ein Verfahren zum Betrieb eines NMR (=Kernspinresonanz)- Spektrometers, insbesondere eines hochauflösenden NMR-Spektrometers, mit einem DDS (=Direct Digital Synthesis)-Generator, der einen NCO (=Numerical Controlled Oscillator) enthält, der zur Erzeugung einer LO (=Local Oscillator)-Frequenz, z.B. der ersten LO-Frequenz $f_{LO1}$ dient und im folgenden "$NCO_L$" genannt wird, wobei die tatsächliche Ausgangsfrequenz des $NCO_L$ im DDS-Generator durch Eingabe eines Zahlenwartes Z definiert wird.

Ein NMR-Spektrometer mit einem solchen DDS ist bekannt aus dem Firmenprospekt "AVANCE / Digital NMR" der Bruker AG, Fällanden, Schweiz vom März 1999, wo insbesondere auf Seite 11 eine Funktionseinheit "DDS" mit dem Verwendungszweck "Frequency and Phase Control" als Bestandteil der CPU für die Frequenzsteuerung gezeigt ist.

Frequenzgeneratoren, die mit direkter digitaler Frequenzsynthese arbeiten, sogenannte DDS-Generatoren (DDS = **D**irect **D**igital **S**ynthesis), sind beispielsweise beschrieben in "Frequency Synthesizers Design Handbook", J.A.Crawford, Artech House, Boston, London, 1994, Seite 346 oder in "Digital PLL Frequency Synthesizers. Theory and Design", U.L.Rohde, Prentice-Hall Inc., Englewood Cliffs, N.J., 1983, Seite 110.

Die Verwendung von DDS-Chips für die digitale Quadratur Detektion (=DQD) in der NMR-Spektroskopie wird beschrieben in Li Gengying, Xie Haibin: "Digital quadrature detection..."; Rev. Sci. Instr. 70 (1999), 1511-1513.

Die DDS-Generatoren besitzen folgende positive Eigenschaften:

Sie erzeugen im Takte einer von aussen zugeführten, stabilen Taktfrequenz $f_S$ Zahlenwerte, die ein Signal mit einer gewünschten Frequenz darstellen. Dieses Signal wird anschliessend in einem DAC (= Digital to Analog Converter) in ein analoges Signal umgewandelt, das praktisch dieselbe Frequenzstabilität wie die Taktfrequenz besitzt und deshalb sehr stabil ist. Die Frequenz lässt sich aber nicht kontinuierlich sondern nur in diskreten Frequenzschritten verändern, die jedoch beim heutigen Stand der Technik sehr klein sein können, nämlich im Millihertz Gebiet für Ausgangsfrequenzen von 10 bis 30 MHz, so dass praktisch eine quasi kontinuierliche Frequenzeinstellung möglich ist.

Die DDS-Generatoren benötigen im Wesentlichen nur digitale IC-Bausteine und können deshalb billig hergestellt werden. Eine sehr vorteilhafte Lösung erreicht man dadurch, dass der ganze DDS-Generator in einem einzigen ASIC-Baustein (ASIC = Appfication Specific Integrated Circuit) untergebracht wird, was bei genügend hoher Stückzahl die Kosten beträchtlich erniedrigen kann und eine besonders dichte Packung der digitalen Funktionselemente erlaubt. Letzteres hat gerade bei sehr schnellen elektronischen Vorgängen, die heute mehr und mehr benötigt werden, grosse Vorteile.

Diesen positiven Aspekten eines DDS-Generators steht jedoch ein sehr gravierender Nachteil gegenüber, nämlich eine für heutige Ansprüche nicht genügend hohe spektrale Reinheit des Ausgangssignals. DDS-Generatoren wurden zwar seit über 10 Jahren in NMR(= Kernspinresonanz)-Spektrometern mit Ertolg eingesetzt, doch heute sind die Anforderungen an die spektrale Reinheit der LO-Signale derart gestiegen, dass diese Generatoren ihre Aufgabe während der Empfangsphase des NMR-Signals nicht mehr einwandfrei erfüllen können.

Die ungenügende spektrale Reinheit des DDS-Generators wird durch das sogenannten Quantisierungsrauschen verursacht. Dieses entsteht dadurch, dass das im DDS-Generator erzeugte Signal quantisiert ist, d.h. eine treppenförmige Annäherung an das gewünschte Signal darstellt, wobei die Zahlenwerte dieser Treppenstufen nur mit einer endlichen Genauigkeit, die durch die maximale Anzahl zur Verfügung stehender Bits gegeben ist, definiert werden.

Das Quantisierungsrauschen ist umso kleiner, je grösser die Anzahl Treppenstufen innerhalb einer Periode, und je genauer die Zahlenwerte dieser Stufen erfasst werden. Die Anzahl Treppenstufen kann aber nicht beliebig erhöht werden, denn auch hier kommt man an eine Grenze, die durch die maximale Taktfrequenz der digitalen Bausteine bestimmt wird.

NMR-Signale in der hochauflösenden NMR besitzen oft sehr starke und zugleich auch sehr schwache Frequenzkomponenten, wobei meistens gerade die schwachen Komponenten von besonderer Bedeutung sind. Man spricht in diesem Fall von einem hohen Dynamikbereich des NMR-Signals. Betrachtet man nun eine der empfindlichsten Mischstufen im NMR-Empfänger, nämlich die erste Mischstufe, bei welcher das LO-Signal ($f_{LO1}$) mit Hilfe des DDS-Generators erzeugt wird und deshalb mit Quantisierungsrauschen behaftet ist, und mischt man dieses LO-Signal mit dem NMR-Signal, dann überträgt sich das Quantisierungsrauschen insbesondere auf die stärksten Frequenzkomponenten des NMR-Signals und erzeugt dadurch im NMR-Spektrum eine mit Störkomponenten verunreinigte Basislinie. Auf dieser verunreinigten Basislinie befinden sich auch die gewünschten schwachen Frequenzkomponenten des NMR-Signals und können dort kaum von den Störkomponenten unterschieden werden. Eine saubere Spektroskopie ist deshalb nicht mehr möglich.

DDS-Generatoren werden in der NMR-Spektroskopie auch heute noch während der relativ unkritischen Sendephase problemlos eingesetzt.

Während der sehr kritischen Empfangsphase hingegen, sind die Ansprüche an die spektrale Reinheit heute derart hoch, dass der DDS-Generator, der die veränderbare LO-Frequenz liefern muss, diesen Ansprüchen nicht mehr genügt. Grund dafür ist das oben beschriebene Quantisierungsrauschen. Eine praktisch realisierbare Methode, dieses Quantisierungsrauschen genügend zu verkleinern, stand bislang nicht in Aussicht, und man musste in allen kritischen Experimenten, wo die spektrale Reinheit von besonderer Bedeutung war, entweder auf diesen eleganten und leistungsfähigen Generator verzichten, oder seine Nachteile in Kauf nehmen.

In der US 5 436 600 wird ein Multi-Frequenz-Synthesizer für die bildgebende Magnetresonanz vorgestellt. Insbesondere wird ein Modulator beschrieben, der die Form von Sendeimpulsen definiert. Störkomponenten, die durch mit 100 kHz gesampelten Hüllkurven erzeugt und durch ein Bandpassfilter nicht vollständig eliminiert werden können, können stärker unterdrückt werden, indem die Sampling-Rate um den Faktor 2,5 auf 250 kHz erhöht wird. Dadurch werden störende Sampling-Komponenten um den Faktor 2,5 auseinandergezogen, wodurch diese auf das Bandpassfilter besser ansprechen.

Aufgabe der vorliegenden Erfindung ist es daher, ein Verfahren mit den eingangs genannten Merkmalen vorzustellen, bei dem ein DDS-Generator auch dann problemlos eingesetzt werden kann, wenn eine sehr hohe spektrale Reinheit erforderlich ist, wobei insbesondere das Quantisierungsrauschen über den für NMR-Messungen relevanten Frequenzbereich möglichst weitgehend eliminiert ist.

Erfindungsgemäss wird diese Aufgabe auf ebenso überraschend einfache wie wirkungsvolle Art und Weise dadurch gelöst, dass der Zahlenwert Z so gewählt wird, dass er nur solche Werte annimmt, welche die Gleichung

$$\underline{Z = n \cdot N/m}$$

erfüllen, wobei Z, n, N und m ganze und positive Zahlen sind, wobei N eine Potenz von 2 mit einem ganzzahligen, positiven Exponenten ist, wobei dieser Exponent die maximale Zahl von Bits im Register des $NCO_L$ bedeutet, wobei m ungefähr gleich $2 \cdot f_S / \triangle B$, n ungefähr gleich $m \cdot f_{out}/f_S$ und m zudem ein ganzzahliger Teiler des Produkts $n \cdot N$ ist, und wobei $f_S$ die Taktfrequenz des $NCO_L$, $\Delta B$ die gewünschte Bandbreite mit hoher spektraler Reinheit, und $f_{out}$ die gewünschte Ausgangsfrequenz des $NCO_L$ bedeuten.

Nach der erfindungsgemässen Lehre dürfen also keine beliebigen, sondern nur ausgewählte Z-Werte dem DDS-Generator eingegeben werden. Durch die spezielle Auswahl wird erreicht, dass die niedrigste auftretende Störfrequenz stets grösser ist als die Repetitionsfrequenz $\Delta f_{Raster}$, mit der sich das Signal des $NCO_L$ exakt wiederholt. Auf diese Weise können die oben beschriebenen Störanteile so weit voneinander entfernt gewählt werden, dass dazwischen das NMR-Spektrum ungestört bleibt.

Bei einer besonders einfach durchzuführenden Variante des erfindungsgemässen Verfahrens, die dementsprechend besonders bevorzugt eingesetzt wird, ist m eine Potenz von 2 mit einem ganzzahligen, positiven Exponenten. Dadurch ergibt sich eine erhebliche Vereinfachung der in dem erfindungsgemässen Verfahren durchzuführenden Rechnungen gegenüber dem allgemeinen Fall, so dass in dieser Verfahrensvariante erheblich weniger Rechenaufwand erforderlich wird.

Besondere Vereinfachung erfährt das Verfahren bei einer Weiterbildung der oben genannten Variante, bei der die Berechnung von Z in folgenden drei Schritten erfolgt

(a) der Wert für m wird mit Hilfe der Gleichung

$$m = 2^{RndDwn\{log(2fs/\Delta B)/log\ 2\}}$$

ermittelt, wobei $\Delta B$ die gewünschte Bandbreite hoher spektraler Reinheit, $f_S$ die Taktfrequenz des NCO und RndDwn einen Abrundungsvorgang auf den nächsten, kleineren, ganzzahligen Wert bedeuten;

(b) der Wert für n wird mit Hilfe der Gleichung

$$n \approx Rnd(m \cdot f_{out}/f_s)$$

ermittelt, wobei $f_{out}$ die gewünscht Frequenz des NCO, m den im ersten Schritt berechneten Wert, und Rnd einen Rundungsvorgang auf den nächstliegenden ganzzahligen Wert bedeuten;

(c) der Wert für Z wird mit Hilfe der Gleichung

$$Z = n \cdot N/m$$

ermittelt, wobei N im Anspruch 1 definiert ist und m sowie n die in Schritt (a) bzw. (b) ermittelten Werte bedeuten.

Vorteilhaft ist auch ein DDS(=Direct Digital Synthesis)-Generator zur Anwendung in NMR-Spektrometem, insbesondere in hochauflösenden NMR-Spektrometem, mit einem NCO (=Numerical Controlled Oscillator), der zur Erzeugung einer LO (=Local Oscillator)-Frequenz $f_{LO1}$ dient und im folgenden "$NCO_L$" genannt wird, der sich dadurch auszeichnet, dass der DDS-Generator mehrere NCO's zur Erzeugung einer Sendefrequenz enthält, und dass der $NCO_L$ eine Taktfrequenz $f_S$ besitzt, welche die Bedingung $f_S = 2^k \cdot f_0$ erfüllt, wobei k eine ganze, positive Zahl ist und $f_0$ die Basisfrequenz bedeutet, aus der alle LO-Frequenzen bis auf zwei, nämlich $f_{LO1}$ für eine Mischstufe sowie die LO-Frequenz für einen DQD (=Digital Quadratur Detector), derart abgeleitet werden, dass sie ganzzahlige Vielfache von $f_0$ sind.

Wenn nämlich mindestens zwei NCO's vorhanden sind, dann kann einer davon dazu benutzt werden, die Phaseninformation für den Empfang des FID-Signals zu liefern und der andere, um während der Sendephase auf eine andere Sendefrequenz zu wechseln. Außerdem wird ermöglicht, dass in den nachfolgenden Mischstufen nur solche Störungskomponenten erzeugt werden, die mit den Rasterkomponenten des $NCO_L$ identisch sind.

Besonders vorteilhaft ist auch eine Ausgestaltung, bei der einer der NCO's kontinuierlich schwingen und eine Referenzphase für alle anderen NCO's bereitstellen kann, indem er seine aktuelle Phase über Schalter den anderen NCO's übergeben kann. Auf diese Weise erreicht man, dass die Anfangsphase des FID-Signals genau definiert ist, so dass für mehrere sukzessive Messdurchgänge eine Phasensynchronität der FID-Signale hergestellt werden kann.

Eine weitere besonders bevorzugte Ausführungsform des DDS-Generators zeichnet sich dadurch aus, dass ein Signalumformer vorgesehen ist, in welchem das Sägezahnsignal eines NCO eine Sägezahn-zu-Sinus-Transformation erfährt, und dass ein weiterer Signalumformer vorgesehen ist, in welchem das Sägezahnsignal dieses NCO auch eine Sägezahn-zu-Cosinus-Transformation erfährt, wodurch zwei in Quadratur stehende Kanäle entstehen, die in einem nachfolgenden Frequenz-Synthesizer für eine Quadratur-Mischstufe verwendet werden können. Durch die Anwendung der Quadratur-Mischstufe entstehen erheblich weniger unerwünschte Mischkomponenten.

Vorteilhaft ist auch eine Ausführungsform, bei der vorzugsweise digitale Multiplikatoren vorgesehen sind, in welche die Signale aus Signalumformern gelangen, wo der gewünschte Amplitudenverlauf während der Sendephase rechnerisch erzeugt werden kann. Damit lässt sich mit ganz einfachen Mitteln ein digitaler Amplitudenmodulator herstellen, der wesentlich genauere Ergebnisse liefert als ein analoger Modulator.

Bevorzugt ist auch eine weitere Ausführungsform des DDS-Generators, bei der ein Dämpfungsglied vorgesehen ist, dessen Phasen- und Dämpfungsfehler dadurch kompensiert werden können, dass die Phasenfehler in Funktion des gewünschten Dämpfungswertes in einem ersten Speicher und die Dämpfungsfehler in Funktion des gewünschten Dämpfungswertes in einem weiteren Speicher gespeichert sind, und dass beim Einstellen eines gewünschten Dämpfungswertes, der zugehörige Phasenfehler mit umgekehrten Vorzeichen in einer Addierstufe zum aktuellen Signal addiert wird, und der entsprechende Dämpfungsfehler mit umgekehrten Vorzeichen zum gewünschten Dämpfungswert addiert und dem Dämpfungsglied zugeführt wird. Durch das Registrieren der Dämpfungsfehler kann somit eine rechnerische Vorkompensation der Signale vorgenommen werden, so dass die gewünschten Dämpfungswerte praktisch ohne Phasen- und Dämpfungsfehler eingestellt werden können.

Vorteilhaft ist auch ein Verfahren zum Betrieb eines DDS-Generators mit DQD, welches sich dadurch auszeichnet, dass während der Empfangsphase eine exakte Positionierung des NMR-Spektrums im NF-Bereich nicht über den $NCO_L$ erfolgt, sondern mit Hilfe des DQD, dessen LO durch den Zahlenwert $Z_Q$ gegeben ist. Dies ermöglicht eine Feineinstellung des NMR-Spektrums auf einem gewünschten Frequenzbereich ohne Erzeugung zusätzlicher Störkomponenten.

Weitere Vorteile der Erfindung ergeben sich aus der Beschreibung und der Zeichnung. Ebenso können die vorstehend genannten und die noch weiter aufgeführten Merkmale erfindungsgemäss jeweils einzeln für sich oder zu mehreren in beliebigen Kombinationen Verwendung finden. Die gezeigten und beschriebenen Ausführungsformen sind nicht als abschliessende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1a     die Zeitfunktion des Ausganassignals eines erfindungsgemäss betriebenen DDS-Generators;

Fig. 1b     das zu Fig. 1a zugehörige Frequenzsprektrum;

Fig. 2     den schematischen Aufbau eines modernen NMR-Spektrometers nach dem Stand der Technik;

Fig. 3     einen Funktionsplan des Haupt-Sendeteiles T1 eines NMR-Spektrometers nach dem Stand der Technik;

Fig. 4     den schematischen Aufbau eines Haupt-Sendeteils gemäss der Erfindung;

Fig. 5a      Signal am Phaseneingang der NCO's;

Fig. 5b      Einfluss des Phasensignals von Fig. 5a auf das Ausgangssignal der NCO's;

Fig. 6a      Signal am Frequenzeingang der NCO's;

Fig. 6b      Einfluss des Frequenzsignals von Fig. 6a auf das Ausgangssignal der NCO's;

Fig. 7a      Ausgangssignal des NCO1 mit einer Frequenz f1;

Fig. 7b      Ausgangssignal des NGO2 mit einer Frequenz f2; und

Fig. 7c      Summensignal aus Fig. 7a und Fig. 7b.

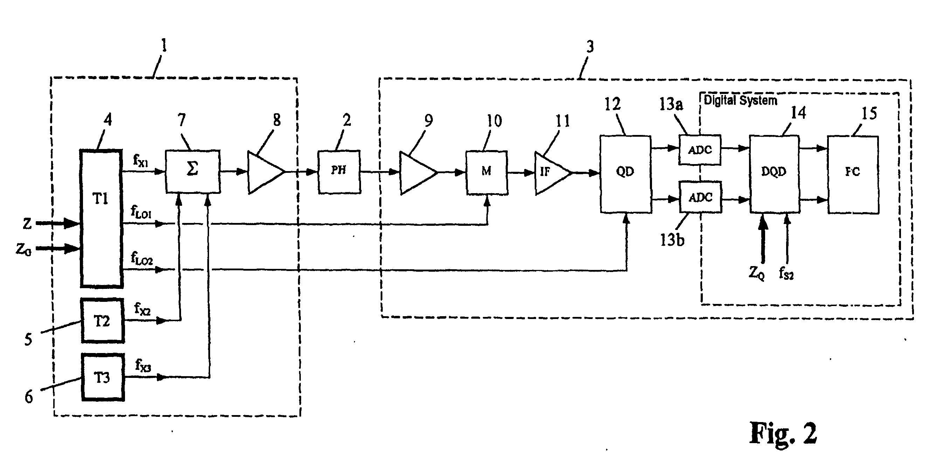

**Fig.2** stellt das Blockschema eines modernen NMR-Spektrometers dar. Die einzelnen Teile sind nachfolgend erklärt:

1          Sendeteil

2          Probenkopf (PH = Probehead)

3          Empfangsteil

4          Haupt-Sendeteil T1, der zugleich die erforderlichen LO-Frequenzen $f_{LO1}$ und $f_{LO2}$ liefert

5          Zweiter Sendeteil T2 zur Anregung eines zweiten Kembereichs

6          Dritter Sendeteil T3 zur Anregung eines dritten Kembereichs

7          Additions-Baustein, mit dem die Ausgangssignale der drei Sender addiert und zum Leistungssender 8 geführt werden

8          Leistungssender, mit dem die Anregungsimpulse hoher Leistung erzeugt werden

9          Vorverstärker mit hohem Signal-zu-Rausch-Abstand

10        Erste Mischstufe, die den frequenzvariablen LO1 benutzt

11        Zwischenverstärker (z.B. bei 20 MHz)

12        Quadratur-Detektor, der den fixen LO2 benutzt (z.B. 20 MHz)

13a, 13b     Analog-zu-Digital-Umwandler für die beiden Ausgangssignale des Quadratur-Detektors 12

14        Digitaler Quadratur-Detektor (DQD = Digital Quadratur Detector), dessen LO durch den Zahlenwert $Z_Q$ gegeben ist. Er arbeitet mit der Taktfrequenz $f_{S2}$

15        Rechner, mit dem unter anderem die Fourier-Transformation der beiden Quadratursignale aus dem DQD 14 erzeugt wird

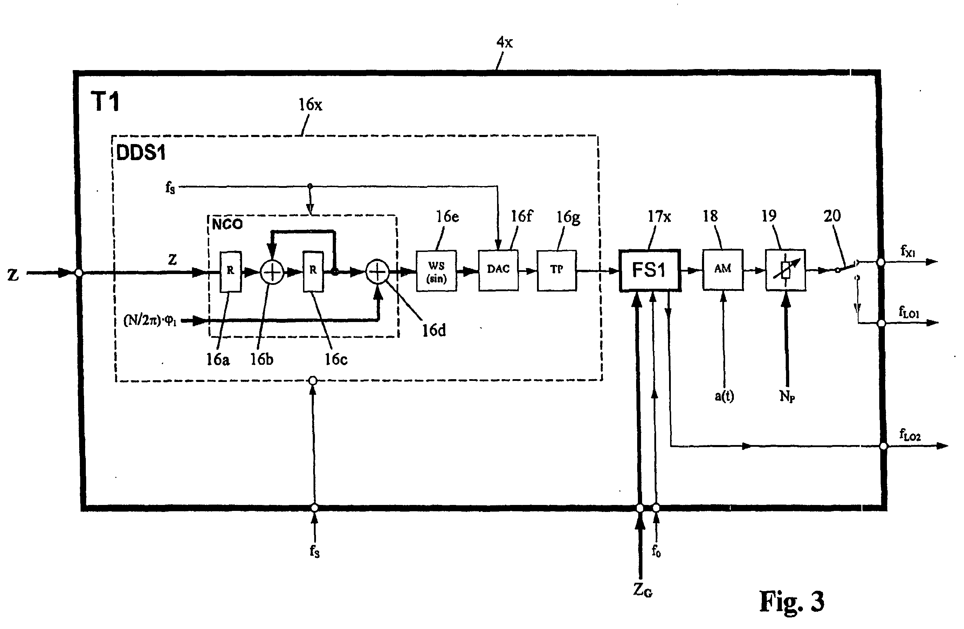

**Fig.3** stellt die Schaltung des Haupt-Sendeteils T1 dar, die zum heutigen Stand der Technik gehört. Der zugehörige DDS-Generator wird über den Eingang Z konventionell angesteuert und erzeugt deshalb Störkomponenten. Durch Verändern der Synthesizer-Frequenz mit Hilfe des Zahlenwertes $Z_G$ und anschliessendem Nachstellen der DDS-Frequenz, muss mühsam versucht werden, eine Kombination zu finden, wo die Störkomponenent im Bereich des Spektrums möglichst klein sind und damit am wenigsten stören.
Die einzelnen Teile des Haupt-Sendeteils T1 sind nachfolgend erklärt:

4x      Haupt-Sendeteil T1 eines NMR-Spektrometers nach dem Stand der Technik

16x    DDS-Generator, dessen Ausgangsfrequenz z.B. im Bereich 5 bis 10 MHz liegt

16a    Register zum Speichern des Zahlenwertes Z im NCO

16b    Additionsstufe, mit welcher der Zahlenwert Z zum Wert des Akkumulators 16c addiert wird, und zwar im Takt der Taktfrequenz $f_S$

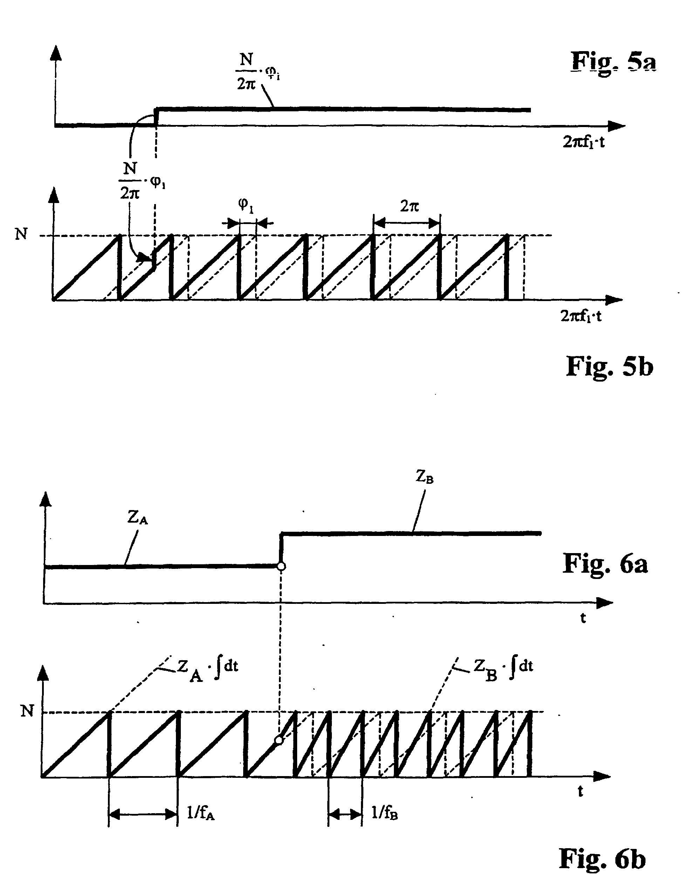

16c    Register, der als Akkumulator arbeitet und zugleich den Ausgang des NCO erzeugt. Das Signal, das dabei entsteht, ist in **Fig.6b** dargestellt. Je grösser der Zahlenwert Z (z.B. $Z_A$, $Z_B$), desto schneller nimmt der Wert im Akkumulator zu, und desto höher wird die Frequenz des Sägezahns

16d    Additionsstufe, mit welcher ein Phasensprung $(N/2\pi)\cdot\varphi_1$ im Ausgangssignal des NCO erzeugt werden kann. Dieser Vorgang ist in **Fig.5a und 5b** dargestellt

16e    Signalumformer, mit dem das Sägezahnsignal aus dem NCO in ein Sinus-Signal umgewandelt wird

16f    Digital-zu-Analog-Umwandler

16g    Tiefpassfilter, der bei jedem Sampling-Prozess notwendig ist, um die Taktfrequenz $f_S$ und deren Vielfachen, sowie die Spiegelung des Signals an der Taktfrequenz zu unterdrücken

17x    Frequenz-Synthesizer, mit welchem die Frequenz des DDS-Generators mit Hilfe des Zahlenwertes $Z_G$ auf die gewünschte Frequenz $f_{X1}$ während der Sendephase, resp. $f_{LO1} = f_{X1}-f_{LO2}$ während der Empfangsphase, hinaufgemischt wird. $f_0$ ist die Basisfrequenz (z.B. 5 MHz) und $f_{LO2}$ die fixe LO-Frequenz des zweiten LO's (z.B. 20 MHz)

18    Allituden-Modulator, mit welchem den Sende-Pulsen die gewünschte Amplitudenform gegeben wird

19    Dämpfungsglied (=Attenuator), um die Sendeleistung mit Hilfe des Zahlenwertes $N_P$ auf den gewünschten Wert zu dämpfen

20    Umschalter, mit dem das Sendesignal während der Sendephase auf den Sende-Kanal $f_{X1}$ und während der Empfangsphase auf den LO-Kanal $f_{LO1}$ geschaltet wird.

Im folgenden wird erklärt, wie der Zahlenwert Z am Eingang des NCO gemäss der vorliegenden Erfolge bestimmt wird:

Wenn man beachtet, dass ein NMR-Spektrum nur einen sehr beschränkten Frequenzbereich beansprucht, bei Protonen z.B. nur ca. 50 bis 100 ppm der ungefähren Kemresonanzfrequenz, dann kann man diese Tatsache dazu verwenden, den DDS-Generator so zu betreiben, dass er in einem gewünschten Frequenzbereich eine sehr hohe spektrale Reinheit besitzt, **ausserhalb dieses Bereiches jedoch Störkomponenten erzeugen darf.** Unter dieser Voraussetzung ist es tatsächlich möglich, DDS-Generatoren zu verwenden, welche die hohen Anforderungen an Stabilität und Reinheit in der hochauflösenden NMR-Spektroskopie erfüllen.

Der erfinderische Gedanke führt zwei Erkenntnisse zusammen, nämlich erstens, dass der DDS-Generator nur in einem beschränkten Frequenzbereich spektral sauber sein muss, und zweitens, dass es Möglichkeiten gibt, den DDS-Generator so zu betreiben, dass er innerhalb dieses beschränkten Frequenzbereiches eine hohe spektrale Reinheit besitzt.

Der so betriebene DDS-Generator liefert neben der gewünschten Frequenz ein Raster von zusätzlichen, jedoch viel kleineren Frequenzkomponenten, die in gleichen Abständen auftreten. Der Abstand wird so gross gewählt, dass darin das halbe NMR-Spektrum Platz hat (die Halbierung deshalb, weil eine Quadratur-Detektion vorausgesetzt wird). Die gewünschte Frequenz sitzt dann genau auf einer Komponente des Rasters und lässt sich in diskreten Schritten verschieben, nämlich von einer Komponente des Rasters zur nächsten.

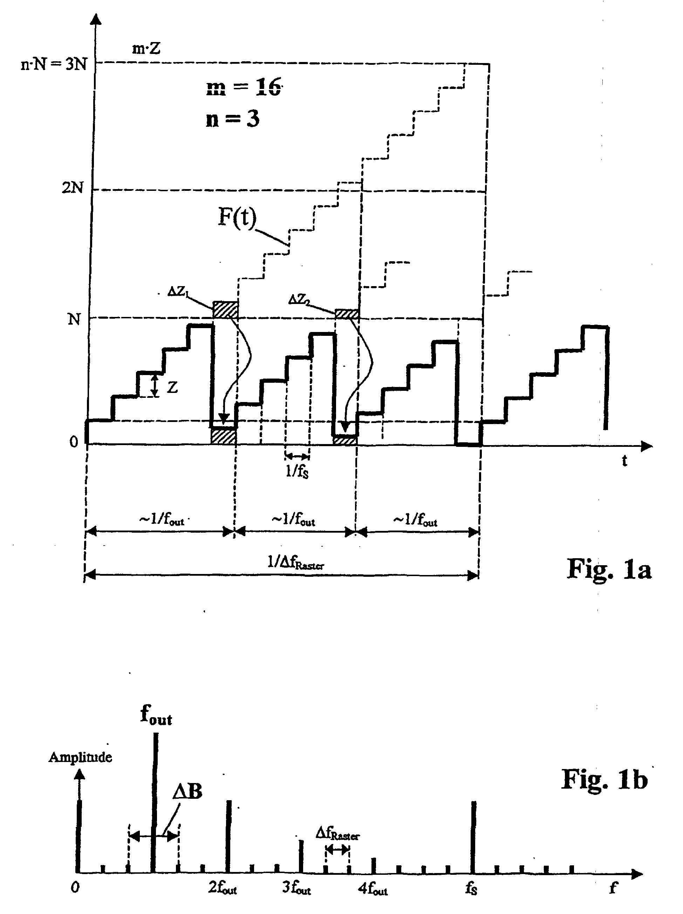

Wie muss nun der DDS-Generator betrieben werden, damit er ein solches Verhalten zeigt? Dazu muss der NCO (= Numeric Controlled Oscillator)im DDS-Generator näher untersucht werden, denn mit diesem lässt sich die Entstehung der Rasterkomponenten am einfachsten erklären. **Fig.1a** zeigt die erforderliche Zeitfunktion des Ausgangssignals, damit das gewünschte Ergebnis erreicht wird. Das dazugehörende Frequenzspektrum ist in **Fig.1b** dargestellt.

In **Fig.1a** wurde für die Treppenfunktion F(t) die Treppenhöhe **Z so gewählt, dass genau m Stufen innerhalb des Bereiches n-N Platz haben.** Dies ist die entscheidende Bedingung, denn dadurch wiederholt sich das Ausgangssignal exakt nach m Perioden der Taktfrequenz $f_S$ und kann deshalb keine Störkomponenten besitzen, die einen kleineren Frequenzabstand haben als diese Wiederholfrequenz $\Delta f_{Raster} = f_S/m$.

Die Störkomponenten stellen ein Frequenzraster mit einem Rasterabstand $\Delta f_{Raster}$ (siehe **Fig.1b**) dar. Zwischen diesen Rasterkomponenten herrscht eine hohe spektrale Reinheit, die für die NMR-Spektroskopie bestens geeignet ist.

Sowohl die Ausgangsfrequenz $f_{out}$ wie auch die Taktfrequenz $f_s$ des NCO liegen genau auf solchen Rasterfrequenzen. Da in unserem Beispiel n=3 gewählt wurde, liegt die Ausgangsfrequenz $f_{out}$ auf der dritten Rasterkomponente, und da ferner m=16 gewählt wurde, liegt die Taktfrequenz $f_s$ auf der 16ten Rasterkomponente.

Nachfolgend sind die einzelnen Begriffe, die in Fig.1a und b vorkommen, einzeln beschrieben:

$f_{out}$ = Ausgangsfrequenz des NCO

$f_s$ = Taktfrequenz des NCO

$\Delta f_{Raster}$ = Frequenzabstand des Rasters und exakte Wiederholfrequenz der Zeitfunktion.

$\triangle B$ = Siehe **Fig.1b**. Frequenzbereich (Bandbreite) links und rechts der Ausgangsfrequenz $f_{out}$, das die gewünschte hohe spektrale Reinheit besitzt und mit Hilfe einer Quadraturdetektion empfangen werden kann

n = Anzahl Perioden von $f_{out}$, bis das Ausgangssignal des NCO sich exakt wiederholt

m = Anzahl Perioden von $f_s$, bis das Ausgangssignal des NCO sich exakt wiederholt

Z = Ganzzahliger, positiver Wert, der im Eingangsregister des NCO gespeichert wird, dort vom NCO aufintegriert wird und an seinem Ausgang ein sägezahnförmiges Signal erzeugt

N = Zahlenwert, der durch die maximale Anzahl verwendeter Bits im NCO bestimmt wird. Wenn dieser z.B. 34 Bit beträgt, dann gilt $N = 2^{34}$. Dieser Wert bestimmt die Rechengenauigkeit. Sobald der NCO beim aufintegrieren diesen Zahlenwert erreicht oder überschreitet, fällt er auf Null zurück und bekommt den Überlaufwert hinzu addiert. Der höchste Zahlenwert, der vom NCO abgegeben werden kann, beträgt $(2^{34}-1)$, weil dies der höchste Wert ist, der mit 34 Bit dargestellt werden kann.

Ausserdem sollen zwei weitere Begriffe N1 und m1 eingeführt und wie folgt definiert werden:

N1 = Maximale anzahl Bits, mit denen der NCO rechnet. Dieser Wert definiert den Zahlenwert $N = 2^{N1}$

m1 = Ganzzahliger, positiver Exponent von 2 für die Definition der Zahl $m = 2^{m1}$

Aus **Fig.1a** lassen sich vier Bedingungen ableiten, die zu erfüllen sind, damit das Ausgangssignal des NCO den gewünschten, zeitlichen Verlauf und damit die geforderte spektrale Reinheit erhält:

$$\text{Bedingung 1:} \quad m \cdot Z = n \cdot N$$
$$\text{Bedingung 2:} \quad (1/\Delta f_{Raster}) = m\,(1/f_s)$$
$$\text{Bedingung 3:} \quad (1/\Delta f_{Raster}) = n\,(1/f_{out})$$
$$\text{Bedingung 4:} \quad m, n, N \text{ und } Z \text{ müssen ganzzahlig sein}$$

Die erste Bedingung lässt sich mit Hilfe der Funktion F(t) in **Fig.1a** ableiten und ist die **zentrale Bedingung der erfinderischen Idee.** Sie definiert nämlich den Zahlenwert Z, der dem NCO zur Aufintegrierung zugeführt werden muss, damit die gewünschte Frequenz $f_{out}$ und die gewünschte Bandbreite $\Delta B$ erfüllt wird:

$$\mathbf{Z = n \cdot N/m} \qquad \mathbf{[1a]}$$

Da Z ganzzahlig sein muss (siehe Bedingung 4), muss m ein gemeinsamer Teiler von n·N sein. Zusammengefasst muss deshalb folgendes gelten:

$$Z = n \cdot N/m$$

Wobei:

**n, N und m ganzzahlig und positiv**

$$N > m > n$$

**N = Potenz von 2**

**m = gemeinsamer Teiler von n·N**

[1b]

Einen ganzzahligen Wert für Z erreicht man aber auch, indem für m eine Potenz von 2 mit einem ganzzahligen, positiven Exponenten m1 gewählt wird. Dies ist ein Spezialfall, der nicht sämtliche Möglichkeiten der Gleichung 1 b umfasst, aber für den praktischen Gebrauch genügend viel Möglichkeiten bietet und einfacher zu handhaben ist:

$$N = 2^{N1}$$

$$m = 2^{m1}$$

$$Z = n \cdot N/m = n \cdot 2^{N1}/2^{m1} = n \cdot 2^{N1-m1}$$

Da N > m und deshalb N1 > m1, ist der obige Wert für Z immer ganzzahlig. Zusammenfassend gilt für den Zahlenwert Z:

$$Z = n \cdot N/m$$

Wobei:

**n, N und m ganzzahlig und positiv**

$$N > m > n$$

**N und m Potenzen von 2**

[1c]

Damit die gewünschten Werte für die Frequenz $f_{out}$ und die Bandbreite $\Delta$B resultieren, müssen ganz bestimmte Werte für m und n gewählt werden. Diese lassen sich mit Hilfe der beiden Bedingungen 2 und 3, die an Hand der Zeitachse in **Fig.1a** abgeleitet wurden, berechnen:

$$\Delta f_{Raster} = \Delta B/2$$

Eingesetzt in Bedingung 1:

$$2/\Delta B = m/f_s$$

$$m = 2fs/\Delta B = 2^{m1}$$

$$m1 = \log(2fs/\Delta B)/\log 2$$

Da m1 ganzzahlig sein soll, muss obiger Ausdruck gerundet werden, und wenn die vorgegebene Bandbreite ΔB nicht unterschritten werden soll, muss <u>abgerundet</u> (=RndDwn) werden:

$$m1 = RndDwn\{\log(2fs/\Delta B)/\log 2\}$$

$$m = 2^{RndDwn\{\log(2fs/\Delta B)/\log 2\}} \qquad [2]$$

Aus den Bedingungen 2 und 3 folgt:

$$m/f_s = n/f_{out}$$

$$2/\Delta B = n/f_{out}$$

$$n = m \cdot f_{out}/ f_s$$

Da auch n ganzzahlig sein muss (Bedingung 4), muss obiger Ausdruck auf die nächstliegende ganze Zahl gerundet (=Rnd) werden:

$$n = Rnd(m \cdot f_{out}/ f_s) \qquad [3]$$

Z lässt sich somit in drei Schritten berechnen:

$$\text{Schritt 1:} \quad m = 2^{RndDwn\{log(2fs/\Delta B)/log\ 2\}}$$

$$\text{Schritt 2:} \quad n = Rnd(m \cdot f_{out} / f_s)$$

$$\text{Schritt 3:} \quad Z = n \cdot N/m \qquad\qquad [4]$$

Wobei:

RndDwn = abrunden auf die nächste, ganzzahlige Zahl

Rnd = auf- oder abrunden auf die nächstliegende ganze Zahl

**Beispiel:**

Gegeben:

$$N = 2^{34} \text{ (34 Bit Rechengenauigkeit)}$$

$$f_s = 80 \text{ MHz}$$

Gewünscht:

$$\Delta B = 9 \text{ kHz}$$

$$f_{out} = 16.3410 \text{ MHz}$$

Resultat der Berechnung:

$$m = 2^{14} = 16'384$$

$$n = 3'347$$

$$Z = 3'347 \cdot 2^{20} = 3'347 \cdot (1'048'576)$$

Da Rundungen notwendig waren, werden die vorgegebenen Werte für $f_{out}$ und $\Delta B$ nicht genau erfüllt:

$$fout = n \cdot f_s /m = 3'347 \cdot 80/16'384 \text{ MHz} = 16.34277$$

$$\Delta B = 2 \cdot fs/m = 2 \cdot 80'000/16'384 = 9.765625 \text{ kHz}$$

Die Ausgangsfrequenz ist um 1.77 kHz höher und die Bandbreite $\Delta B$ um 0.765625 kHz grösser als verlangt. Die gewünschten Werte werden somit nicht exakt erfüllt, dafür steht jedoch ein Frequenzband $\Delta B$ zur Verfügung, das eine saubere NMR-Spektroskopie erlaubt. Eine exakte Einstellung der Ausgangsfrequenz ist aber trotzdem notwendig und muss mit Hilfe anderer Mittel erreicht werden, wie weiter unten näher beschrieben wird.

Im weiteren werden die Unterschiede zwischen der Sendephase und der Empfangsphase erläutert:

Da die Anregung des NMR-Signals keine hohen Anforderungen an die spektrale Reinheit des Anregungssignals stellt, dürfen alle DDS-Generatoren, welche die benötigten Sendefrequenzen erzeugen, bedenkenlos nach dem heutigen Stand der Technik aufgebaut sein. Solche DDS-Generatoren erlauben problemlos eine Feinsteinstellung der Frequenz und damit eine Positionierung der Sendefrequenz in die Mitte des NMR-Spektrums.

Ganz anders verhält es sich während der Empfangsphase. Dort wird der DDS-Generator dazu benutzt, die LO-Frequenz $f_{LO1}$ zu erzeugen, und da diese spektral sehr rein sein muss, dürfen die Z-Werte für den zugehörigen NCO nur die erfinderischen Werte annehmen, denn nur so werden die Störkomponenten im gewünschten Frequenzbereich vermieden. Das hat jedoch zur Folge, dass die Frequenz des DDS-Generators nur in Schritten von $\triangle f_{Raster}$ eingestellt werden kann, und somit eine Feinsteinsstellung der Frequenz nicht mehr möglich ist.

Im folgenden wird beschrieben, wie eine Feinsteinstellung der Frequenz während der Empfangsphase trotzdem realisiert werden kann, insbesondere wie das NMR-Spektrum genau in den gewünschten NF-Bereich positioniert wird:

Grundsätzlich könnte mit jeder LO-Frequenz das NMR-Spektrum genau in den gewünschten NF-Bereich positioniert werden. Es muss nicht unbedingt die LO-Frequenz $f_{LO1}$ dazu benutzt werden, aber von den übrigen LO-Frequenzen sind auch nicht alle dazu geeignet, weil eine genaue Frequenzeinstellung meistens auf Kosten der spektralen Reinheit geht. Es gibt jedoch eine LO-Frequenz, die sich dafür besonders gut eignet, nämlich die, welche zum DQD 14 (Digital Quadratur Detector, siehe **Fig.2**) ganz am Schluss der Empfangskette gehört und mit dem Zahlenwert $Z_Q$ definiert wird. Dadurch, dass diese die tiefste Frequenz unter allen LO-Frequenzen besitzt und rein digital erzeugt wird, kann ihr Signal mit grosser Genauigkeit und praktisch ohne Nebenwellen erzeugt werden. Mit diesem LO ist es somit möglich, das NMR-Spektrum mit der erforderlichen Genauigkeit im NF-Bereich zu positionieren, ohne dadurch eine Verschlechterung der spektralen Reinheit in Kauf nehmen zu müssen.

Der DQD gehört zum Stand der Technik und ist im Wesentlichen eine digital ausgeführte Quadratur-Mischstufe, welche das NMR-Spektrum rechnerisch hinuntermischt, so dass dessen Mittelpunkt auf die Frequenz Null zu liegen kommt.

Der Vollständigkeit halber soll noch erwähnt werden, dass die Quadraturmischstufe 12 vor dem DQD das NMR-Spektrum nicht genau auf Null hinuntermischt, und zwar aus zwei Gründen: erstens infolge der Grobheit der Rasterung $\Delta f_{Raster}$ des ersten LO's, und zweitens weil dies gar nicht erwünscht wäre, da normalerweise der Bereich um die Frequenz Null durch die Einflüsse von Netzleitungen, Laboreinrichtungen, Flickerrauschen, etc. stark gestört ist. Der anschliessende DQD mischt zwar das NMR-Spektrum dann doch auf Null hinunter, aber da dies rein rechnerisch erfolgt, kommen keine weiteren Störkomponenten hinzu.

Die Positionierung des NMR-Spektrums um die Frequenz Null herum erfolgt an drei verschiedenen Stellen mit Hilfe von groben, feinen und feinsten Schritten, wie nachfolgend beschrieben:

1. Im Synthesizer 17y werden mit dem Zahlenwert $Z_G$ die gröbsten Frequenzschritte von fo (z.B. 5 MHz) erzeugt.

2. Mit dem $NCO_L$ 22 im DDS-Generator 16y werden mit dem Zahlenwert Z die feineren Schritte eingestellt.

3. Mit dem DQD 14 werden mit dem Zahlenwert $Z_Q$ die feinsten Schritte erzeugt.

Die Bedingungen an die LO-Frequenzen, damit keine zusätzlichen Störkomponenten entstehen, sollen im folgenden erläutert werden:

Auch wenn die erste LO-Frequenz $f_{LO1}$ dank den ausgesuchten Z-Werten keine Störkomponenten im gewünschten Frequenzbereich besitzt, könnten trotzdem alle anderen LO-Frequenzen in den zugehörigen Mischprozessen zusätzliche Störkomponenten erzeugen. Um dies zu verhindern, müssen sie bestimmte Bedingungen erfüllen, die nachfolgend definiert werden.

Die LO-Frequenzen im Frequenz-Synthesizer 17y ($f_1$, $f_2$ und $n3 \cdot f_0$) und im Empfänger 3 ($f_{LO2}$), ausgenommen zwei, nämlich $f_{LO1}$ für die erste Mischstufe 10 sowie die LO-Frequenz im DQD 14, werden von der Basisfrequenz $f_0$ abgeleitet und sind ganzzahlige Vielfache von $f_0$. Damit die Mischvorgänge, die mit diesen LO-Frequenzen durchgeführten werden, keine zusätzlichen Störkomponenten ausser dem Raster $\Delta f_{Raster}$ erzeugen, genügt es, dass die Basisfrequenz $f_0$ ebenfalls eine ganzzahlige Vielfache p des Rasters $\Delta f_{Raster}$ ist:

$$f_0 = p \cdot \Delta f_{Raster}$$

Es lässt sich jedoch zeigen, dass obige Bedingung automatisch erfüllt wird, wenn die Taktfrequenz $f_S$ des NCO eine ganzzahlige Vielfache $2^k$ von $f_0$ ist, wobei k ganzzahlig und positiv sein muss:

$$f_S = 2^k \cdot f_0 \qquad\qquad [5a]$$

Dies lässt sich einfach zeigen:

$$f_0 = f_S/2^k = m \cdot \Delta f_{Raster}/2^k = 2^{m1} \cdot \Delta f_{Raster}/2^k$$

$$f_0 = 2^{(m1-k)} \cdot \Delta f_{Raster}$$

Solange $\triangle f_{Raster}$ kleiner oder gleich $f_0$ ist, muss m1 grösser oder gleich k sein und deshalb $2^{(m1-k)}$ immer ganzzahlig sein.

Zusammenfassend müssen folgende Bedingungen erfüllt sein, damit $f_0$ ein ganzzahliges Vielfaches von $\triangle f_{Raster}$ ist, und als Folge davon, die Mischvorgänge keine zusätzlichen Störkomponenten ausser dem Raster mit dem Frequenzabstand $\cdot \Delta f_{Raster}$ erzeugen:

$$\boxed{\begin{array}{l} f_S = 2^k \cdot f_0 \\[4pt] \text{wobei:} \\[4pt] k = \text{positiv und ganzzahlig} \\[4pt] \Delta f_{Raster} = f_S/m \leq f_0 \end{array}} \qquad [5b]$$

Im folgenden wird die Entstehung des Quantisierungsrasters am Ausgang des DDS-Generators erläutert:

Das Ausgangssignal des $NCO_L$ besitzt eine sägezahnförmige Kurvenform, die in den beiden Bausteinen 25a und 25b in eine Sinus- resp. Cosinus-Funktion umgewandelt werden muss, damit im Wesentlichen eine einzige Frequenzkomponente $f_{out}$ entsteht. Dazu wird das Ausgangssignal mit $2\pi/N$ multipliziert, wodurch die Zahlenachse in Fig. 1a zur Phasenachse wird. Die sägezahnförmige Phasenkurve des $NCO_L$ darf infolge der $2\pi$-Periodizität durch die Treppenfunktion F(t) ersetzt werden, die den Vorteil eines monotonen Verlaufs Ober die Periodenzeit $1/\Delta f_{Raster}$ besitzt. Anschliessend erhält man durch Berechnung des Sinus resp. Cosinus der Phasenkurve $(2\pi/N) \cdot F(t)$ die beiden gewünschten sinusförmigen Ausgangssignale:

$$Z_{out1} = \sin[(2\pi/N)\cdot F(t)] \qquad\qquad [6a]$$

$$Z_{out2} = \cos[(2\pi/N)\cdot F(t)] \qquad\qquad [6b]$$

Diese beiden sinusförmigen Signale $Z_{out1}$ und $Z_{out2}$ besitzen bereits ein Frequenzspektrum, das sehr viel reiner ist als das in **Fig.1b** dargestellte. Es könnte sogar vollkommen rein sein, wenn die Berechnung der Gleichungen 6a und 6b beliebig genau ausgeführt werden könnte. Bereits eine Genauigkeit von 34 Bit würde genügen, um das Spektrum der beiden erzeugten Signale so rein zu machen, dass das Raster $\Delta f_{Raster}$ vernachlässigbar klein würde, und nur die Frequenzkomponenten der Taktfrequenz $f_S$ und seiner Vielfachen sowie die Spiegelung der beiden Signale an der Taktfrequenz als Störelemente vorhanden wären, wie dies übrigens bei jedem Samplingprozess der Fall ist. Diese Störelemente sind aber kein Problem, denn sie werden in den beiden Tiefpass-Filtern 32a und 32b vollständig eliminiert.

Die Entstehung eines vollkommen reinen Signals ist leicht einzusehen, wenn man beachtet, dass die Zahlenwerte der treppenförmigen Phasenkurve $(2\pi/N)$-F(t) auf einer exakten Geraden liegen würden. Die Steigung d$\varphi$/dt dieser Geraden ergäbe exakt die gewünschte Kreisfrequenz $2\pi\cdot f_{out}$.

Da jedoch der Rechenvorgang eine endliche Genauigkeit besitzt, sind die Werte der Treppenstufen auf- oder abgerundete Werte und liegen nicht genau auf der exakten, geraden Phasenkurve. Die Abweichungen von der exakten Phasenkurve werden als Quantisierungsrauschen bezeichnet. Dieses hat aber in unserem Fall nichts mit Rauschen im üblichen Sinne zu tun, denn der Fehlerverlauf wiederholt sich nach jeder Periode $1/\Delta f_{Raster}$ und erzeugt ein periodisches Quantisierungssignal, das im Frequenzspektrum als Frequenzraster mit einem Abstand $\triangle f_{Raster}$ in Erscheinung tritt. Anstatt von Quantisierungsrauschen zu sprechen, ist es in diesem Fall naheliegender von einem **Quantisierungsraster** zu sprechen.

Die sinusförmigen Signale erzeugen somit ebenfalls ein Frequenzraster, genau so wie das sägezahnförmige Signal, nur mit viel kleineren Amplitudenwerten. Alle vorangehenden Berechnungen, die auf Grund der Sägezahnfunktion gemacht wurden, gelten deshalb qualitativ auch für das sinusförmige Signal.

Wie schon früher erwähnt, würde eine Genauigkeit von 34 Bit bereits genügen, um die Rasterkomponenten vernachlässigbar klein zu halten. Damit hätten wir einen praktisch idealen DDS-Generator vor uns, der eine spektral reine Frequenz liefern würde, die zudem sehr fein einstellbar wäre. Die vorangehende Theorie zur Berechnung von diskreten Z-Werten für den VCO wäre demnach nicht mehr notwendig.

Die Genauigkeit von 34 Bit ist aber aus dynamischen Gründen nicht realisierbar. Die beiden sinusförmigen Funktionen lassen sich nämlich nicht direkt während der Laufzeit berechnen, weil die heutigen digitalen Bausteine dafür zu langsam sind. Die Sinusfunktion muss deshalb durch diskrete Zahlenwerte in einer Tabelle zur Verfügung stehen, und alle Werte dazwischen müssen durch lineare Interpolation ermittelt werden, und zwar während der Laufzeit. Letzteres ist von der Dynamik her möglich, weil die lineare Interpolationsberechnung, im Gegensatz zur Berechnung des Sinus, ein viel einfacherer Rechenvorgang ist.

Nun ist es aber leider so, dass mit steigender Rechengenauigkeit auch die Anzahl der benötigten Sinus-Stützpunkte zunimmt, so dass bei einer Genauigkeit von 34 Bit die Zahl dieser Stützpunkte zu einem für heutige Verhältnisse unzulässig grossen Speicherbedarf führen würde. Die Genauigkeit der Sinus-Berechnung muss aus diesem Grunde auf 16 Bit reduziert werden, indem nur die oberen 16 Bit der 34 Bit Zahlen aus dem VCO berücksichtigt werden. Diese geringere Genauigkeit genügt aber leider nicht mehr, um die Quantisierungseffekte vernachlässigen zu können.

Im weiteren wird die Erzeugung der Sendefrequenz und der ersten LO-Frequenz mit Hilfe von NCO's erläutert:

Der erfindungsgemässe DDS-Generator 16y besitzt einen bis mehrere NCO's zur Erzeugung der Sendefrequenz, z.B. zwei, nämlich NCO1 21a und NCO2 21b, sowie einen einzigen $NCO_L$ 22 zur Erzeugung der ersten LO-Frequenz $f_{LO1}$. NCO1 ist ständig eingeschaltet und liefert die Bezugsphase, mit der die Phasen der übrigen NCO's bei Bedarf synchronisiert werden können. Dies erfolgt mit den beiden Schaltern 23a und 23b, welche eine Übertragung der momentanen Phase des NCO1 auf die übrigen NCO's erlaubt.

Es gibt spezielle NMR-Experimente, bei denen während der Sendephase die Frequenz von einem Wert $f_1$ zu einem neuen Wert $f_2$ und wieder zurück zum alten Wert $f_1$ geschaltet werden muss. Dies liesse sich mit einem einzigen NCO realisieren, indem dieser, wie in **Fig.6a und 6b** dargestellt, entsprechend umgeschaltet würde. Dabei würde jedoch die ursprüngliche Phase von $f_1$ verloren gehen, und das würde während der Empfangsphase zu Phasenproblemen führen.

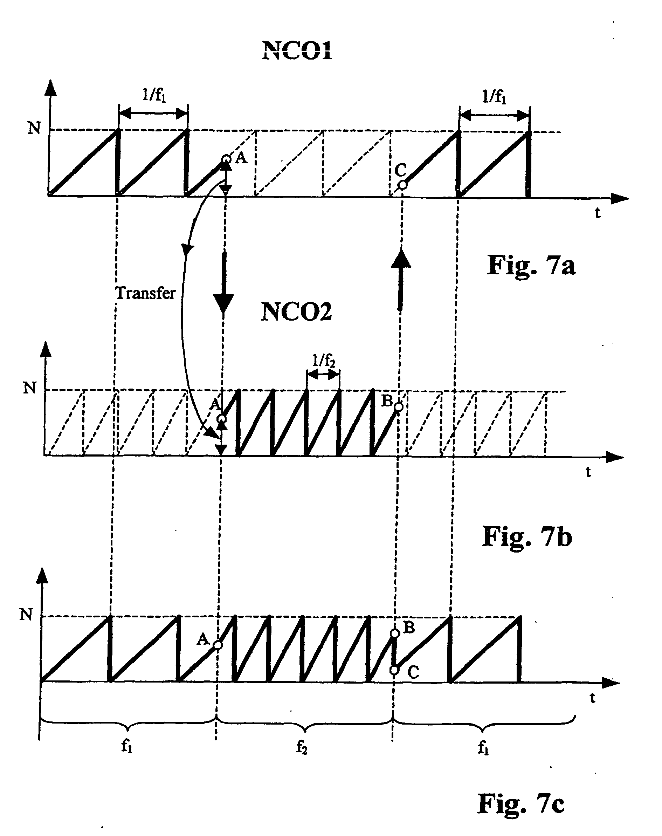

Wenn nun aber beim oben beschriebenen Experiment zwei NCO's verwendet werden, nämlich NCO1 für die Frequenz $f_1$ und NCO2 für die Frequenz $f_2$, dann geht die ursprüngliche Phase von $f_1$ nicht verloren, weil wieder zurück auf den ursprünglichen NCO1, der ungestört weiter schwingen konnte, geschaltet wird. Zudem lässt sich beim Schalten von $f_1$ auf $f_2$ die Phase von $f_1$ mit Hilfe des Schalters 23a auf $f_2$ übertragen und auf diese Weise ein Phasensprung beim Umschalten vermeiden. Das hat Vorteile, indem das Experiment sauberere Ergebnisse liefert. In **Fig.7a, 7b und 7c** sind die beschriebenen Vorgänge zum besseren bildlichen Verständnis dargestellt.

Mit dem $NCO_L$ 22 wird die LO-Frequenz $f_{LO1}$ erzeugt, die eine hohe spektrale Reinheit haben muss und deshalb mit den erfindungsgemässen Z-Werten angesteuert wird. Zu Beginn jedes Aquisitionsvorganges, d.h. der Aufnahme des FID's (= Free Induction Decay), muss die Phase des Bezugsoszillators NCO1 21 a über den Schalter 23b auf den $NCO_L$ übertragen werden, damit phasensynchrone FID's entstehen, die im Rechner 15 aufsummiert werden können.

Das gesamte Spektrometer lässt sich wiederum durch das Blockschema in **Fig.2** darstellen. Dieses gilt sowohl für den Stand der Technik wie auch für die erfindungsgemässe Schaltung. Die Beschreibung der einzelnen Bausteine wurde bereits bei der Erläuterung des Standes der Technik beschrieben.

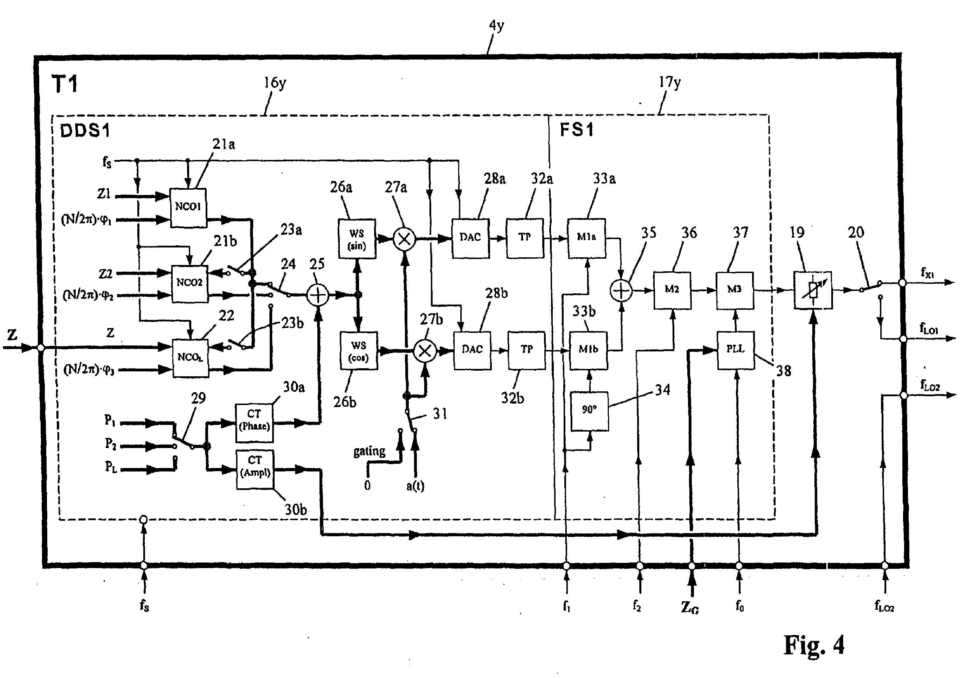

Der Haupt-Sendeteil T1 ist in Fig. 4 gezeigt und im folgenden näher erläutert:

| | |
|---|---|
| 4y | Haupt-Sendeteil T1 |
| 16y | DDS-Generator |
| 17y | Frequenz-Synthesizer, der Frequenzänderungen in Schritten von $f_0$ (z.B. 5 MHz) erlaubt. Diese werden mit Hilfe des PLL-Oszillators 38 (PLL = Phase Lock Loop) erzeugt und mit dem Zahlenwert $Z_G$ festgelegt |
| 19 | Dämpfungsglied, mit dem die Ausgangsleistung des erzeugten Signals eingestellt wird |
| 20 | Schalter, mit dem die Sendefrequenz $f_{X1}$ während der Sendephase, sowie die LO-Frequenz $f_{LO1}$ während der Empfangsphase gewählt wird |
| 21a | NCO, der kontinuierlich schwingt und die Bezugsphase für die beiden anderen NCO's 21b und 22 liefert. Dieser NCO sowie der NCO 21b dienen der Erzeugung der gewünschten Sendefrequenz für die Anregungs-Pulse |
| 21b | NCO, der zusammen mit NCO 21a die gewünschte Sendefrequenz für die Anregungs-Pulse erzeugt |
| 22 | NCO zur Erzeugung der ersten LO-Frequenz $f_{LO1}$ |
| 23a, 23b | Schalter, mit denen die Bezugsphase des NCO 21a auf die beiden NCO's 21b und 22 übertragen werden kann |
| 24 | Umschalter, mit dem der gewünschte NCO gewählt wird |
| 25 | Summationsstufe zur Addition einer Phasenkorrektur, die den Phasenfehler des Dämpfungsgliedes 19 korrigieren soll |
| 26a, 26b | Zwei Signalumformer, die das ankommende, sägezahnförmige Signal in eine Sinus- resp. Cosinus-Funktion umwandeln |
| 27a, 27b | Zwei Multiplikatoren, mit denen der Amplitudenverlauf der beiden sinusförmigen Signale definiert wird |
| 28a, 28b | Zwei Digital-zu-Analog-Wandler, mit denen die digitalen Signale in analoge Signale umgewandelt werden |
| 29 | Schalter, der mit Schalter 24 gekoppelt ist, und mit dem der gewünschte Dämpfungswert für das Dämpfungsglied 19 definiert wird. Je nachdem ob mit Schalter 24 NCO1, NCO2 oder $NCO_L$ gewählt wurde, wird mit diesem Schalter der entsprechende Dämpfungswert P1, P2 resp. $P_L$ gewählt |
| 30a | RAM-Speicher, der die Phasenfehler des Dämpfungsgliedes 19 in Funktion des gewünschten Dämpfungswertes enthält |
| 30b | RAM-Speicher, der die Dämpfungsfehler des Dämpfungsgliedes 19 in Funktion des gewünschten Dämpfungswertes enthält |
| 31 | Schalter, um die Amplituden-Modulation a(t) ein- oder auszuschalten. Im ausgeschalteten Zustand wird der Wert 0 den Multiplikatoren 27a und 27b zugeführt, wodurch diese ebenfalls den Wert 0 weitergeben und |

eine vollständige Unterdrückung der Signale verursachen

| 32a. 32b | Zwei Tiefpassfilter, die bei jedem Sampling-Prozess notwendig sind, um die Taktfrequenz $f_S$ und deren Vielfachen, sowie die Spiegelung des Signals an der Taktfrequenz zu unterdrücken |

33a, 33b      Quadratur-Mischstufe, mit der das Signal um den Wert der LO-Frequenz $f_1$ (z.B. 160 MHz) hinaufgemischt wird

35      Additionsstufe, die zur Quadratur-Mischstufe 33a, 33b gehört

36      Mischstufe, mit der das Signal um den Wert der LO-Frequenz $f_2$ (z.B. 720 MHz) hinaufgemischt wird

37      Mischstufe, bei der die LO-Frequenz von einem PLL-Oszillator 38 geliefert wird, der vielfache Werte von $f_0$ liefert, und mit dessen Hilfe das Signal wieder hinuntergemischt, oder falls erforderlich, noch weiter hinaufgemischt wird

38      PLL-Oszillator, mit der die LO-Frequenz für die Mischstufe 37 erzeugt wird. Die LO-Frequenz kann beispielsweise zwischen 865 und 1500 MHz in Schritten von $f_0 = 5$ MHz eingestellt werden, wobei die gewünschte Einstellung über den Zahlenwert $Z_G$ erfolgt.

**Patentansprüche**

1. Verfahren zum Betrieb eines NMR(= Kemspinresonanz)-Spektrometers, insbesondere eines hochauflösenden NMR-Spektrometers, mit einem DDS (=Direct Digital Synthesis)-Generator, der einen NCO (=Numerical Controlled Oscillator) enthält, der zur Erzeugung einer LO (=Local Oscillator)-Frequenz, z.B. der ersten LO-Frequenz $f_{LO1}$ dient, und der im folgenden "$NCO_L$" genannt wird, wobei die tatsächliche Ausgangs-Frequenz des $NCO_L$ im DDS-Generator durch Eingabe eines Zahlenwertes Z definiert wird,
**dadurch gekennzeichnet,**
**dass** dieser Zahlenwert Z so gewählt wird, dass er nur solche Werte annimmt, welche die Gleichung

$$Z = n \cdot N / m$$

erfüllen, wobei Z, n, N und m ganze und positive Zahlen sind, wobei N eine Potenz von 2 mit einem ganzzahligen, positiven Exponenten ist, wobei dieser Exponent die maximale Zahl von Bits im Register des $NCO_L$ bedeutet, wobei m ungefähr gleich $2 \cdot f_S / \Delta B$, n ungefähr gleich $m \cdot f_{out} / f_S$ und m zudem ein ganzzahliger Teiler des Produkts n·N ist, und wobei $f_S$ die Taktfrequenz des $NCO_L$ (22), $\Delta B$ die gewünschte Bandbreite mit hoher spektraler Reinheit, und $f_{out}$ die gewünschte Ausgangsfrequenz des $NCO_L$ (22) bedeuten.

2. Verfahren nach Anspruch 1, **dadurch gekennzeichnet, dass** m eine Potenz von 2 mit einem ganzzahligen, positiven Exponenten ist.

3. Verfahren nach Anspruch 2, **dadurch gekennzeichnet, dass** die Berechnung von Z in folgenden drei Schritten erfolgt:

     (a) der Wert für m wird mit Hilfe der Gleichung

$$m = 2^{RndDwn\{log(2f_S/\Delta B)/log\,2\}}$$

ermittelt, wobei $\Delta B$ die gewünschte Bandbreite hoher spektraler Reinheit, $f_S$ die Taktfrequenz des NCO und RndDwn einen Abrundungsvorgang auf den nächsten, kleineren, ganzzahligen Wert bedeuten;
     (b) der Wert für n wird mit Hilfe der Gleichung

$$n = Rnd(m \cdot f_{out}/f_s)$$

ermittelt, wobei $f_{out}$ die gewünscht Frequenz des NCO, m den im ersten Schritt berechneten Wert, und Rnd einen Rundungsvorgang auf den nächstliegenden ganzzahligen Wert bedeuten;

(c) der Wert für Z wird mit Hilfe der Gleichung

$$Z = n \cdot N/m$$

ermittelt, wobei N im Anspruch 1 definiert ist und m sowie n die in Schritt (a) bzw. (b) ermittelten Werte bedeuten.

## Claims

1. Method of operating an NMR (=nuclear magnetic resonance) spectrometer, in particular, a high-resolution NMR spectrometer, comprising a DDS (=Direct Digital Synthesis) generator containing an NCO (=Numerical Controlled Oscillator), referred to below as $NCO_L$, for generating an LO (=Local Oscillator) frequency, e.g. the first LO frequency $f_{LO1}$, wherein the actual output frequency of the $NCO_L$ in the DDS generator is defined through input of a numerical value Z,

   **characterized in that**

   this numerical value Z is selected in such a manner that it takes only values which meet the equation

   $$Z = n \cdot N/m$$

   wherein Z, n, N, and m are integer and positive numbers, wherein N is a power of 2 with an integer positive exponent, wherein said exponent represents the maximum number of bits in the $NCO_L$ register, wherein m is approximately $2 \cdot f_S/\Delta B$, n is approximately $m \cdot f_{out}/f_S$, and m is moreover an integer divisor of the product of $n \cdot N$ and wherein $f_S$ is the clock frequency of the $NCO_L$(22), $\Delta B$ is the desired bandwidth with high spectral purity and $f_{out}$ is the desired output frequency of the $NCO_L$(22).

2. Method according to claim 1, **characterized in that** m is a power of 2 having an integer positive exponent.

3. Method according to claim 2, **characterized in that** Z is calculated in the following three steps:

   (a) the value for m is determined using the equation

   $$m = 2^{RndDwn\{log(2fs/\Delta B)/log\ 2\}}$$

   wherein $\Delta B$ is the desired bandwidth of high spectral purity, $f_S$ is the clock frequency of the NCO and RndDwn is a rounding-off process to the next lower integer value;

   (b) the value for n is determined using the equation

   $$n = Rnd(m \cdot f_{out}/f_S)$$

   wherein $f_{out}$ is the desired frequency of the NCO, m is the value calculated in the first step and Rnd is a rounding process to the next integer value;

   (c) the value for Z is determined using the equation

$$Z = n \cdot N/m$$

wherein N is defined in claim 1 and m and n are the values determined in steps (a) and (b), respectively.

**Revendications**

1.  Procédé d'opération d'un spectromètre RMN (= résonance magnétique nucléaire), en particulier d'un spectromètre RMN à haute résolution, avec un générateur DDS (= Direct Digital Synthesis/synthèse digitale directe) qui contient un NCO (= Numerically Controlled Oscillator/oscillateur contrôlé numériquement) qui sert à générer une fréquence LO (= Local Oscillator/oscillateur local), p. ex. la première fréquence LO $f_{LO1}$, et qui est appelé dans la suite « NCOL », la fréquence de sortie effective du $NCO_L$ étant définie dans le générateur DDS par entrée d'une valeur numérique Z, **caractérisé par le fait que** cette valeur numérique Z est choisie de manière à ne prendre que des valeurs qui satisfont à l'équation

$$Z = n \cdot N/m$$

dans laquelle Z, n, N et m sont des nombres entiers et positifs, N est une puissance de 2 avec un exposant entier positif, cet exposant représentant le nombre maximum de bits dans le registre du $NCO_L$, m étant approximativement égal à $2 \cdot f_S/\Delta B$, n étant approximativement égal à $m \cdot f_{out} < /f_S$ et m étant de plus un diviseur entier du produit $n \cdot N$, $f_S$ représentant la fréquence d'horloge du $NCO_L$ (22), $\Delta B$ la largeur de bande de grande pureté spectrale souhaitée et $f_{out}$ la fréquence de sortie souhaitée du $NCO_L$ (22).

2.  Procédé selon la revendication 1, **caractérisé par le fait que** m est une puissance de 2 avec un exposant entier positif.

3.  Procédé selon la revendication 2, **caractérisé par le fait que** le calcul de Z s'effectue en trois étapes :

    (a) la valeur de m est déterminée à l'aide de l'équation

    $$m = 2^{RndDwn\{log(2fs/\Delta B)/log\,2\}}$$

    dans laquelle $\triangle B$ représente la largeur de bande de grande pureté spectrale souhaitée, $f_S$ la fréquence d'horloge du NCO et RndDwn une opération d'arrondi à la valeur entière inférieure la plus proche ;
    (b) la valeur de n est déterminée à l'aide de l'équation

    $$n = Rnd(m \cdot f_{out}/f_S)$$

    dans laquelle $f_{out}$ représente la fréquence souhaitée du NCO, m la valeur calculée à la première étape et Rnd une fonction d'arrondi à la valeur entière la plus proche ;
    (c) la valeur de Z est déterminée à l'aide de l'équation

    $$Z = n \cdot N/m$$

    dans laquelle N est défini dans la revendication 1 et m ainsi que n représentent les valeurs déterminées respectivement à l'étape (a) et à l'étape (b).

**Fig. 1a**

**Fig. 1b**

Fig. 2

Fig. 3

EP 1 271 173 B1

Fig. 4

Fig. 5a

Fig. 5b

Fig. 6a

Fig. 6b

# NCO1

1/f₁ ... N ... A ... C ... t

**Fig. 7a**

Transfer

# NCO2

N ... A ... 1/f₂ ... B ... t

**Fig. 7b**

N ... A ... B ... C ... t

f₁ ... f₂ ... f₁

**Fig. 7c**